# EUROPEAN PATENT APPLICATION

(11) **EP 4 671 867 A2**
(43) Date of publication of application: **31.12.2025**
(21) Application number: 25182980.0
(22) Date of filing: 16.06.2025
(51) Int. Cl.: G03F 7/20

(54) **LITHOGRAPHY PROCESSES FOR DUAL DAMASCENE STRUCTURES**

(30) Priority: 24.06.2024 US 202463663686 P
(71) Applicant: Applied Materials, Inc., Santa Clara, CA 95054 (US)
(72) Inventor: CHUANG, Chun-chih, 74144 Tainan (TW); WANG, YingChiao, Santa Clara, 95054 (US); LAIDIG, Thomas L., Santa Clara, 95054 (US); KANG, Chung-Shin, Santa Clara, 95054 (US); CHEN, Jang Fung, Santa Clara, 95054 (US); TSAI, Chi-Ming, Santa Clara, 95054 (US); HSIEH, Chen-Yuan, 74144 Tainan (TW)
(74) Representative: Zimmermann & Partner Patentanwälte mbB

(57) **Abstract**

Embodiments of the disclosure include apparatus and methods for fabricating dual damascene structures. First portions within a first region of a photoresist are exposed to electromagnetic radiation from a radiation source at a first dose. The first portions have first depths and first surface areas. Second portions within the first region of the photoresist are exposed to electromagnetic radiation from the radiation source at a second dose. The second portions have second depths and second surface areas, each of the first surface areas of the first portions is disposed within one of the second surface areas of the second portions. Third portions within a second region of the photoresist are exposed to the electromagnetic radiation from the radiation source at the first dose. The third portions have the first depths and the first surface areas.

## Description

### BACKGROUND

### Field

Embodiments described herein generally relate to lithography processes. More specifically, embodiments of the present disclosure relate to lithography processes for forming dual damascene structures.

### Description of the Related Art

Structures are fabricated using a light sensitive material (e.g., photoresist) disposed on a substrate by exposing portions of the light sensitive material to radiation having a particular wavelength which causes the exposed portions of the light sensitive material to become soluble in a developer. The portions of the light sensitive material exposed to the radiation are then removed using the developer to form the structures. Typically, in order to fabricate structures with multiple features (e.g., overlapping features), the portions of the light sensitive material need to be exposed to the radiation multiple times in multiple scans (e.g., one for each overlapping feature). However, each pass/scan adds time to the fabrication process and decreases throughput.

Accordingly, there is a need in the art for a desirable technique that solves the problems described above.

### SUMMARY

To the accomplishment of the foregoing and related ends, the one or more aspects comprise the features hereinafter fully described and particularly pointed out in the claims. The following description and the appended drawings set forth in detail certain illustrative features of the one or more aspects. These features are indicative, however, of but a few of the various ways in which the principles of various aspects may be employed.

Embodiments of the present disclosure provide a method that includes Exposing first portions within a first region of a photoresist to electromagnetic radiation from a radiation source at a first dose. The first portions have first depths and first surface areas. Second portions within the first region of the photoresist are exposed to electromagnetic radiation from the radiation source at a second dose. The second portions have second depths and second surface areas, each of the first surface areas of the first portions is disposed within one of the second surface areas of the second portions. Third portions within a second region of the photoresist are exposed to the electromagnetic radiation from the radiation source at the first dose. The third portions have the first depths and the first surface areas.

Embodiments of the present disclosure provide an apparatus that includes a radiation source configured to direct electromagnetic radiation towards a photoresist disposed over a substrate. The apparatus includes one or more non-transitory computer readable media storing executable instructions that, when executed by at least one processor, cause the at least one processor to perform operations including exposing first portions within a first region of the photoresist to electromagnetic radiation from the radiation source at a first dose. The first portions have first depths and first surface areas. Second portions within the first region of the photoresist are exposed to electromagnetic radiation from the radiation source at a second dose. The second portions have second depths and second surface areas, each of the first surface areas of the first portions is disposed within one of the second surface areas of the second portions. Third portions within a second region of the photoresist are exposed to the electromagnetic radiation from the radiation source at the first dose. The third portions have the first depths and the first surface areas.

Embodiments of the present disclosure provide a lithography system, including an electromagnetic radiation source. The electromagnetic radiation source is configured to receive one or more user inputs specifying electromagnetic radiation at a first dose, electromagnetic radiation at a second dose, a first set of dimensions for the electromagnetic radiation at the first dose, and a second set of dimensions for the electromagnetic radiation at the second dose. The electromagnetic radiation source is configured to output iterations of the electromagnetic radiation at the first dose having the first set of dimensions and the electromagnetic radiation at the second dose having the second set of dimensions. A substrate support is configured to actuate relative to the electromagnetic radiation source. The substrate support is configured to expose first portions within a first region of a photoresist to the electromagnetic radiation at the first dose having the first set of dimensions, expose second portions within the first region of the photoresist to the electromagnetic radiation at the second dose having the second set of dimensions, and expose third portions within a second region of the photoresist to the electromagnetic radiation at the first dose having the first set of dimensions.

### BRIEF DESCRIPTION OF THE DRAWINGS

So that the manner in which the above recited features of embodiments of the present disclosure can be understood in detail, a more particular description of the disclosure, briefly summarized above, may be had by reference to embodiments, some of which are illustrated in the appended drawings. It is to be noted, however, that the appended drawings illustrate only typical embodiments of this disclosure and are therefore not to be considered limiting of its scope, for the disclosure may admit to other equally effective embodiments.
Figure 1 is a perspective view of a lithography system, in accordance with certain embodiments of the present disclosure.
Figure 2 is a schematic representation of a radiation directing system, in accordance with certain embodiments of the present disclosure.
Figures 3A, 3B, 3C, 3D, and 3E illustrate schematic representations of forming a dual damascene structure in a photoresist disposed over a substrate, in accordance with certain embodiments of the present disclosure.
Figures 4A, 4B, 4C, 4D, and 4E illustrate schematic representations of forming a plurality of dual damascene structures in a photoresist disposed over a substrate, in accordance with certain embodiments of the present disclosure.
Figure 5 is a process flow diagram illustrating a method for exposing multiple portions of a photoresist to electromagnetic radiation from a radiation source, in accordance with certain embodiments of the present disclosure.

To facilitate understanding, identical reference numerals have been used, where possible, to designate identical elements that are common to the figures. It is contemplated that elements disclosed in one embodiment may be beneficially utilized on other embodiments without specific recitation.

### DETAILED DESCRIPTION

Embodiments of the present disclosure generally relate to lithography processes. More specifically, embodiments of the present disclosure relate to lithography processes for forming a multilevel structure, such as a dual damascene structure. In one or more embodiments, a lithography system exposes first portions within a first region of a light sensitive material, which for simplicity of discussion purposes is referred to herein as a photoresist material, disposed over a substrate to electromagnetic radiation from a radiation source at a first dose. Second portions within the first region of the photoresist are exposed to electromagnetic radiation from the radiation source at a second dose. In some examples, both the first portions and the second portions within the first region can be exposed to electromagnetic radiation without changing an alignment (e.g., without realigning) with the radiation source.

In some embodiments, in order to form a desired pattern in the photoresist layer the electromagnetic radiation emitted from the radiation source from the first dose to the second dose, an output of the radiation source is lowered between the first and second doses. In other embodiments, in order to change the electromagnetic radiation emitted from the radiation source from the first dose to the second dose, a total duration of exposure is reduced for the second portions relative to a total duration of exposure for the first portions. In one or more embodiments, removing the first portions of the photoresist is configured to form, for example, vias and removing the second portions of the photoresist is configured to form trenches. Collectively, the vias and the trenches form a plurality of dual damascene like structures.

In various embodiments, the first portions and the second portions form an exposed portion within the first region of the photoresist. Additional exposed portions are formed by alternatively/iteratively exposing additional first portions within a second region of the photoresist to the electromagnetic radiation from the radiation source at the first dose, and exposing additional second portions within the second region of the photoresist to the electromagnetic radiation from the radiation source at the second dose. The exposed portion and the additional exposed portions are developed using a developer solution to form, for example, a plurality of dual damascene structures in the photoresist. By exposing the first portions to the electromagnetic radiation at the first dose and the second portions to the electromagnetic radiation at the second dose within the first region, the plurality of dual damascene structures have smooth surfaces and are formed in a single scan/pass. The single scan/pass eliminates risk of position drift between scans/passes. This is an improvement over conventional techniques which require multiple scans/passes in order to form a dual damascene structure. Additionally, the described techniques are an improvement relative to conventional techniques which form structures using a single exposure to the electromagnetic radiation which results in non-smooth "rippled" surfaces of the structures.

### Lithography Process Examples

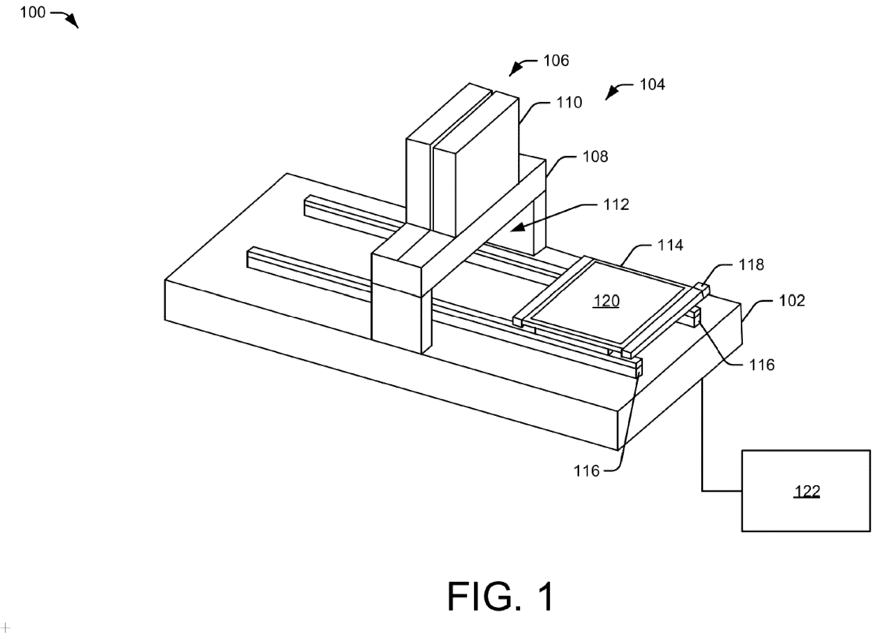

Figure 1 is a perspective view of a lithography system 100. The lithography system 100 includes a stage 114 and a processing apparatus 104. In some embodiments, a substrate 120 is supported by the stage 114 is and the stage 114 is supported by a pair of tracks 116 that are disposed on a slab 102. The stage 114 is configured to actuate along the pair of tracks 116. In one or more embodiments, the pair of tracks 116 includes a pair of parallel magnetic channels.

In various embodiments, an encoder 118 is coupled to the stage 114 and the encoder 118 is configured to communicate a location of the stage 114 to a controller 122. In some embodiments, the controller 122 includes a computing device having one or more processors, memory, and storage. The one or more processors can include central processing units, graphics processing units, accelerators, etc. The memory includes main memory for storing instructions for the one or more processors to execute or data for the one or more processors to operate on. For example, the memory includes random access memory (RAM). The storage includes mass storage for data or instructions. As an example and not by way of limitation, the storage may include a removable disk drive, flash memory, an optical disc, a magneto-optical disc, magnetic tape, or a Universal Serial Bus drive or two or more of these. The storage may include removable or fixed media and may be internal or external to the computing device. The storage may include any suitable form of non-volatile, solid-state memory, or read-only memory. The controller 122 includes a non-transitory computer readable medium or media. The non-transitory computer readable medium or media may include one or more semiconductor-based or other integrated circuits (ICs) (such, as for example, field-programmable gate arrays or application-specific ICs), hard disk drives, hybrid hard drives, optical discs, optical disc drives, magneto-optical discs, magneto-optical drives, solid-state drives, RAM drives, any other suitable non-transitory computer readable storage medium/media, or any suitable combination. The non-transitory computer readable medium or media may be volatile, non-volatile, or a combination of volatile and non-volatile.

In some examples, the encoder 118 communicates the location of the stage 114 relative to one or more components of the lithography system 100 such as the pair of tracks 116 to the controller 122. In some embodiments, the controller 122 is electrically and/or communicatively coupled to the processing apparatus 104, the stage 114, and the encoder 118. In one or more examples, the processing apparatus 104 may communicate information to the controller 122 regarding processing and/or aligning of the substrate 120. For example, the processing apparatus 104 may communicate information to the controller 122 that indicates to the controller 122 that processing of the substrate 120 is complete. The one or more processors of the controller 122 execute instructions which cause the one or more processors to determine which tasks are performed on the substrate 120 and control processing time for the tasks. The instructions executed by the one or more processors of the controller 122 also cause the one or more processors to control a position of the substrate 120 relative to the processing apparatus 104.

The processing apparatus 104 is illustrated to include a support 108 and a processing unit 106. In some embodiments, the processing apparatus 104 is disposed above and around the pair of tracks 116 and includes an opening 112 for the pair of tracks 116 and the stage 114 to pass under the processing unit 106. In various embodiments, the processing unit 106 includes one or more radiation sources enclosed in a case 110. In some embodiments, the one or more radiation sources are configured to emit optical radiation (e.g., light having wavelengths in a range of 100 nanometers to 1 millimeter) such as visible light, infrared light, ultraviolent light or light having a wavelength outside of the optical radiation spectrum. In other embodiments, the one or more radiation sources are configured to emit other forms of electromagnetic radiation. When the stage 114 and the substrate 120 are disposed below the processing unit 106, the one or more radiation sources of the processing unit 106 are capable of exposing a surface of the substrate 120 (or a material disposed over the surface of the substrate 120) to electromagnetic radiation in order to perform one or more tasks determined to be performed on the substrate 120 by the one or more processors of the controller 122.

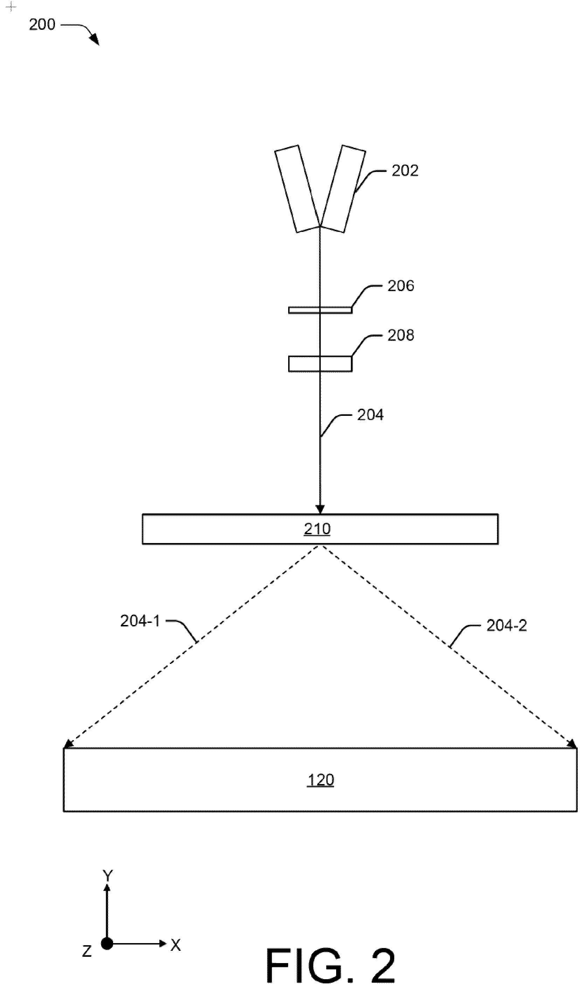

Figure 2 is a schematic representation of a radiation directing system 200. In some examples, the radiation directing system 200 is included in the processing unit 106. The radiation directing system 200 is illustrated to include a radiation source 202 which emits electromagnetic radiation 204. The radiation source 202 can include a laser, one or more light emitting diodes (LEDs), or another source of radiation capable of generating the electromagnetic radiation 204 (e.g., at one or more particular wavelengths). In some embodiments, the electromagnetic radiation 204 passes through an aperture 206 and a lens 208 before reaching a digital micromirror device (DMD) 210. In various embodiments, the controller 122 is electrically and/or communicatively coupled to the DMD 210 via the processing apparatus 104. In some embodiments, the DMD 210 includes more than about four million mirrors that may each be individually controllable or controllable in groups. For example, the one or more processors of the controller 122 execute instructions which cause the one or more processors to actuate/activate the mirrors of the DMD 210. By actuating/activating the mirrors of the DMD 210, the electromagnetic radiation 204 can be directed within a first range 204-1, 204-2 in the X-direction and within a second range (not shown) in the Z-direction.

In some examples, as the electromagnetic radiation 204 reaches the mirrors of the DMD 210, the electromagnetic radiation 204 can be reflected in a first direction (e.g., within the first range 204-1, 204-2 in the X-direction and/or within the second range in the Z-direction) relative to the substrate 120 by a first mirror of the mirrors of the DMD 210 as a first "shot" of the electromagnetic radiation 204 towards the substrate 120. In one or more embodiments, as the electromagnetic radiation 204 reaches the mirrors of the DMD 210, the electromagnetic radiation 204 may also be reflected in a second direction (e.g., within the first range 204-1, 204-2 in the X-direction and/or within the second range in the Z-direction) relative to the substrate 120 by a second mirror of the mirrors of the DMD as a second "shot" of the electromagnetic radiation 204 towards the substrate 120. In some embodiments, as the electromagnetic radiation 204 reaches the mirrors of the DMD 210, the electromagnetic radiation 204 can be reflected in many different directions relative to the substrate 120 by many different mirrors of the DMD 210 as many "shots" of the electromagnetic radiation 204 towards the substrate 120.

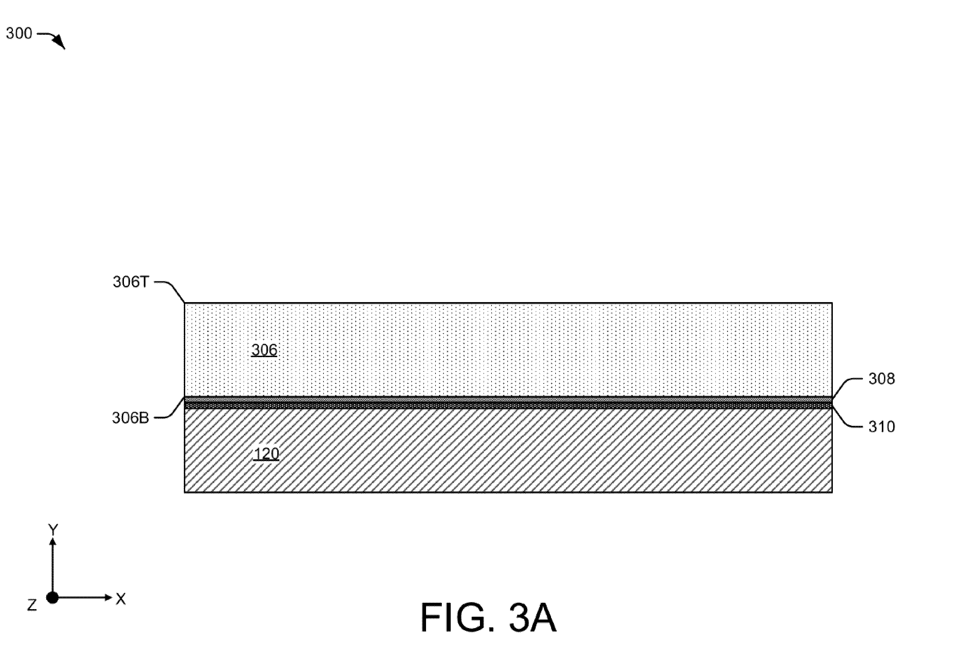

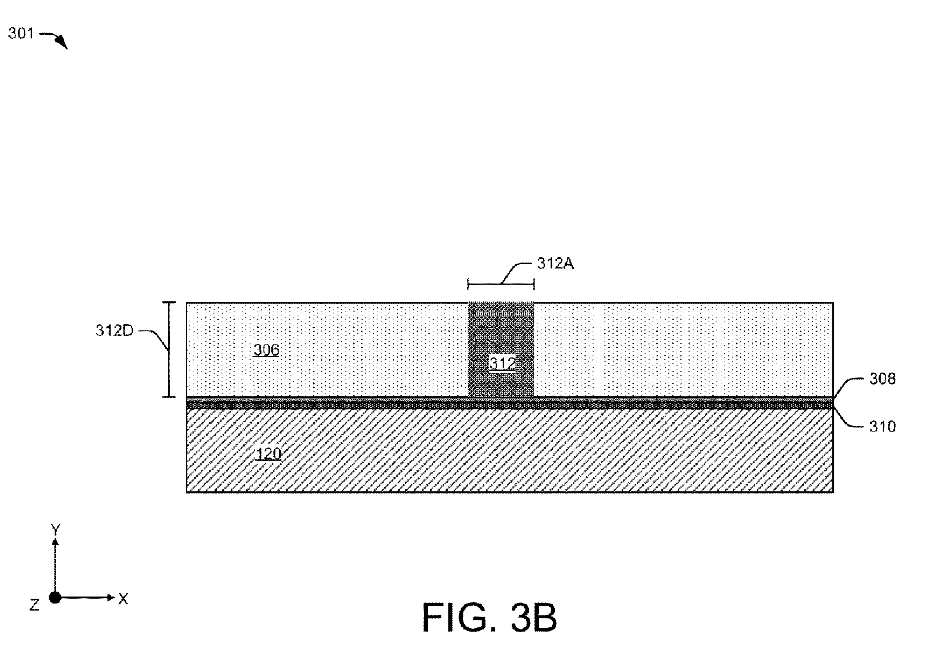

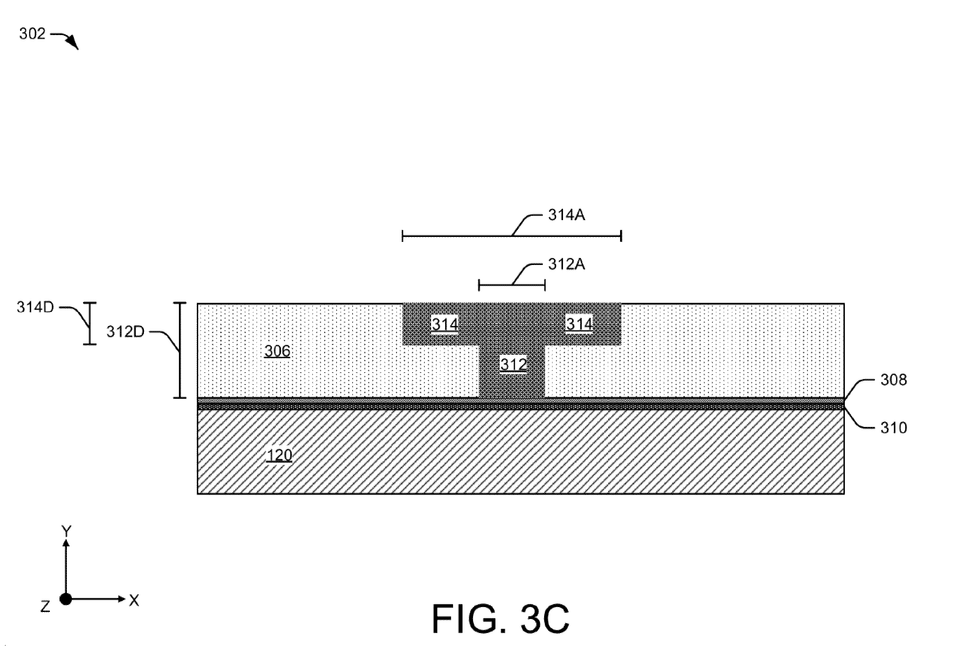

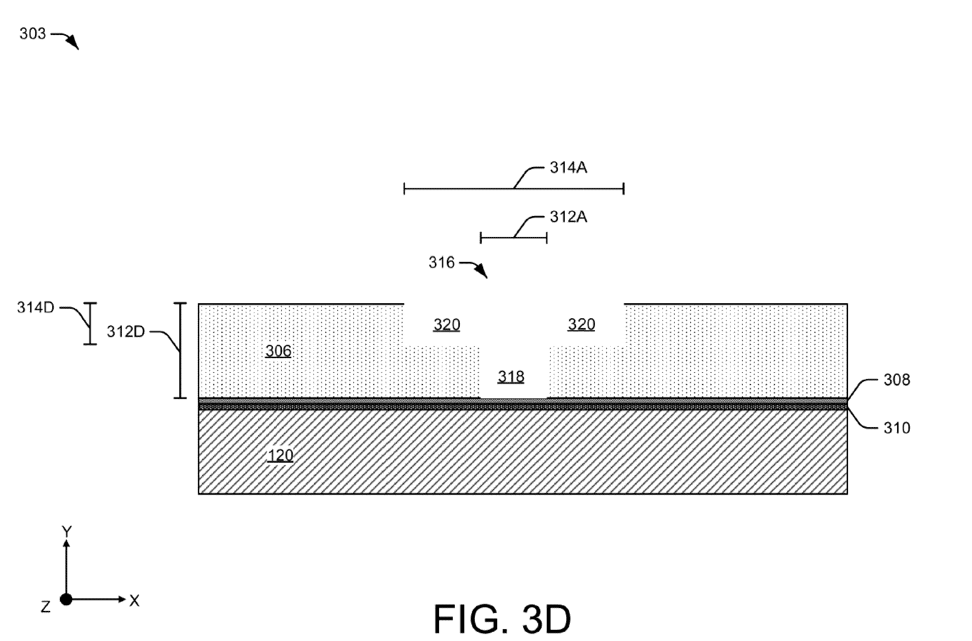

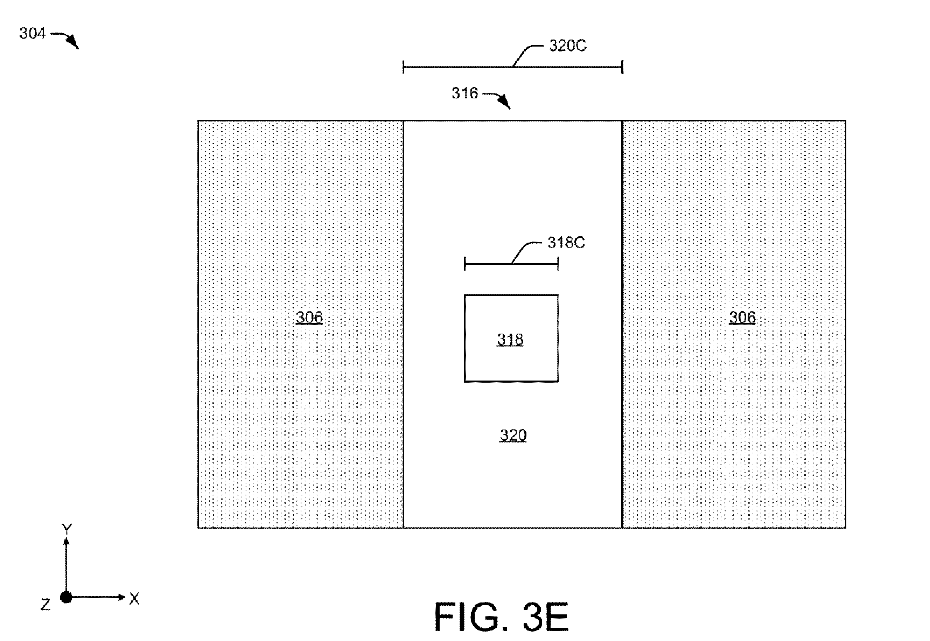

Figures 3A, 3B, 3C, 3D, and 3E illustrate schematic representations of forming a dual damascene structure 316 in a photoresist 306 disposed over a substrate 120. Figure 3A illustrates a representation 300 of the photoresist 306 disposed over the substrate 120. The photoresist 306 may be a positive photoresist or a negative photoresist, and the photoresist 306 is generally described as a positive photoresist in various examples. In some embodiments, a first metal layer 308 such as a copper alloy may be disposed over a second metal layer 310 such as a titanium alloy between the substrate 120 and the photoresist 306. For example, the photoresist 306 includes a top surface 306T and a bottom surface 306B, and the bottom surface 306B may interface with the first metal layer 308.

Generally, forming structures in the photoresist 306 which include multiple features having different dimensions such the dual damascene structure 316 involves competing considerations of total processing time and final quality of the structures. For example, the dual damascene structure 316 can be formed in the photoresist 306 using a single exposure of the electromagnetic radiation 204 emitted from the radiation source 202 and a mask to form the different features. In this example, the single exposure of the electromagnetic radiation 204 minimizes the total processing time but at a cost of the final quality of the structures which have non-smooth, "rippled" surfaces.

In an alternative example, the dual damascene structure 316 may be formed in the photoresist 306 by exposing the entire photoresist 306 to first exposures of the electromagnetic radiation 204 emitted from the radiation source 202 to form first features. In the alternative example, after forming the first features, the radiation source 202 and the photoresist 306 are realigned to sequentially expose the entire photoresist 306 to second exposures of the electromagnetic radiation 204 to form second features. If the radiation source 202 and the photoresist 306 are precisely aligned to form the second features, then the alternative example improves the final quality of the structures which have smooth surfaces. However, this improvement in the final quality comes at a cost of the total processing time. Additionally, if the radiation source 202 and the photoresist 306 are not precisely aligned to form the second features, then the alternative example does not necessarily improve the final structure quality relative to the previous example with the single exposure.

Figure 3B illustrates a representation 301 of exposing a first portion 312 of a photoresist 306 to the electromagnetic radiation 204 emitted from the radiation source 202 at a first dose. As shown, the first portion 312 includes a first surface area 312A and a first depth 312D. In some embodiments, the first surface area 312A is an area in a range of about 20 micrometers squared (µm²) to about 30 µm² such as about 25 µm². In other embodiments, the first surface area 312A is an area of less than about 20 µm² or greater than about 30 µm².

The first depth 312D is proportional to one or more components of the first dose. In various embodiments, the first dose includes a first total duration of exposure of the electromagnetic radiation 204 from the radiation source 202 to the first portion 312 of the photoresist 306. In general, decreasing the first total duration of exposure decreases the first depth 312D.

In some examples, the first dose includes a first intensity of the electromagnetic radiation 204 from the radiation source 202. The first intensity of the electromagnetic radiation 204 from the radiation source 202 is a first power transferred per a first unit area (e.g., the first surface area 312A). Generally, decreasing the first intensity decreases the first depth 312D. In one or more embodiments, the first intensity of the electromagnetic radiation 204 is from about 100 mJ/cm² to about 400 mJ/cm², such as about 200 mJ/cm².

In various embodiments, the first depth 312D extends from the top surface 306T of the photoresist 306 to the bottom surface 306B of the photoresist 306. Accordingly, increasing the first total duration of exposure and/or the first intensity does not increase the first depth 312D. As shown in Figure 3B, the first depth 312D exposes a portion of the first metal layer 308. In some embodiments, the first depth 312D may be a depth in a range of about 4.0 micrometers (µm) to about 5.0 µm such as about 4.35 µm. In other embodiments, the first depth 312D can be a depth of less than about 4.0 µm or greater than about 5.0 µm.

Figure 3C illustrates a representation 302 of exposing a second portion 314 of a photoresist 306 to electromagnetic radiation 204 emitted from a radiation source 202 at a second dose. In some examples, in order to change the electromagnetic radiation 204 emitted from the radiation source 202 from the first dose to the second dose, the controller 122 lowers an output of the radiation source 202. For example, the one or more processors of the controller 122 execute instructions which cause the one or more processors to reduce a power setting for the radiation source 202 which decreases an intensity of the electromagnetic radiation 204 emitted from the radiation source 202.

In various examples, in order to change the electromagnetic radiation 204 emitted from the radiation source 202 from the first dose to the second dose, the controller 122 does not lower the output of the radiation source 202 but instead changes the output from a full shot for the first dose to a partial shot for the second dose. In certain examples, the one or more processors of the controller 122 execute instructions which causes the one or more processors to decrease a duty cycle for the radiation source 202 from, for example, 100 percent for the first dose to, for example, 50 percent for the second dose. In some examples, in the full shot for the first dose, the electromagnetic radiation 204 is output by the radiation source 202 in 100 shots at a particular output energy dose level. In these examples, in the partial shot for the second dose, the electromagnetic radiation 204 is output by the radiation source 202 in 50 shots at the particular output energy dose level.

The second portion 314 is illustrated to include a second surface area 314A and a second depth 314D. In various embodiments, the second depth 314D is less than the first depth 312D and the second surface area 314A is greater than the first surface area 312A. In some embodiments, the second surface area 314A is an area in a range of about 200 µm² to about 400 µm² such as about 300 µm². In other embodiments, the second surface area 314A is an area of less than about 200 µm² or greater than about 400 µm².

The second depth 314D is proportional to one or more components of the second dose. The second dose includes a second total duration of exposure of the electromagnetic radiation 204 from the radiation source 202 to the second portion 314 of the photoresist 306. In general, increasing the second total duration of exposure increases the second depth 314D and decreasing the second total duration of exposure decreases the second depth 314D. In some examples, in order to change the electromagnetic radiation 204 emitted from the radiation source 202 from the first dose to the second dose, the controller 122 changes an output duration of the radiation source 202 from the first total duration of exposure to the second total duration of exposure. For example, the one or more processors of the controller 122 execute instructions that cause the one or more processors to change the output duration of the radiation source 202.

In one or more embodiments, the second dose may include a second intensity of the electromagnetic radiation 204 from the radiation source 202. In some examples, the second intensity can be the same as the first intensity. In other examples, the second intensity may be different from the first intensity (e.g., less than the first intensity). Generally, increasing the second intensity increases the second depth 314D and decreasing the second intensity decreases the second depth 314D.

In various embodiments, the second depth 314D extends from the top surface 306T of the photoresist 306 to a portion of the photoresist 306 that is above the bottom surface 306B. In some embodiments, the second depth 314D is a depth in a range of about 2.0 µm to about 3.0 µm such as about 2.3 µm. In other embodiments, the second depth 314D may be a depth of less than 2.0 µm or greater than 3.0 µm. In one or more embodiments, the second intensity of the electromagnetic radiation 204 is from about 50 mJ/cm² to about 200 mJ/cm², such as about 100 mJ/cm².

Notably, in a positive tone photoresist case, exposing the first and second portions 312, 314 of the photoresist 306 to the electromagnetic radiation 204 from the radiation source 202 causes the first and second portions 312, 314 to become soluble in a developer solution. For example, the electromagnetic radiation 204 from the radiation source 202 initiates a chemical reaction (e.g., a cleavage of chemical bonds) in the first and second portions 312, 314 of the photoresist 306 causing the first and second portions 312, 314 to become soluble in the developer solution.

Figure 3D illustrates a representation 303 of a dual damascene structure 316 formed in a photoresist 306. The developer solution (not shown) is applied to the representation 302 to remove the first and second portions 312, 314 and form the dual damascene structure 316 in the photoresist 306. As shown, the dual damascene structure 316 includes a via 318 formed by removing the first portion 312 and a trench 320 formed by removing the second portion 314.

Figure 3E illustrates a plan view 304 of a dual damascene structure 316. As illustrated in the plan view 304, the via 318 includes a critical dimension 318C. In some embodiments, the critical dimension 318C may be a length in a range of about 3 µm to about 7 µm such as about 5 µm. In other embodiments, the critical dimension 318C may be a length of less than about 3 µm or more than about 7 µm. The trench 320 also includes a critical dimension 320C. In some examples, the critical dimension 320C may be a length in a range of about 7 µm to about 13 µm such as about 10 µm. In other examples, the critical dimension 320C can be a length of less than about 7 µm or more than about 13 µm.

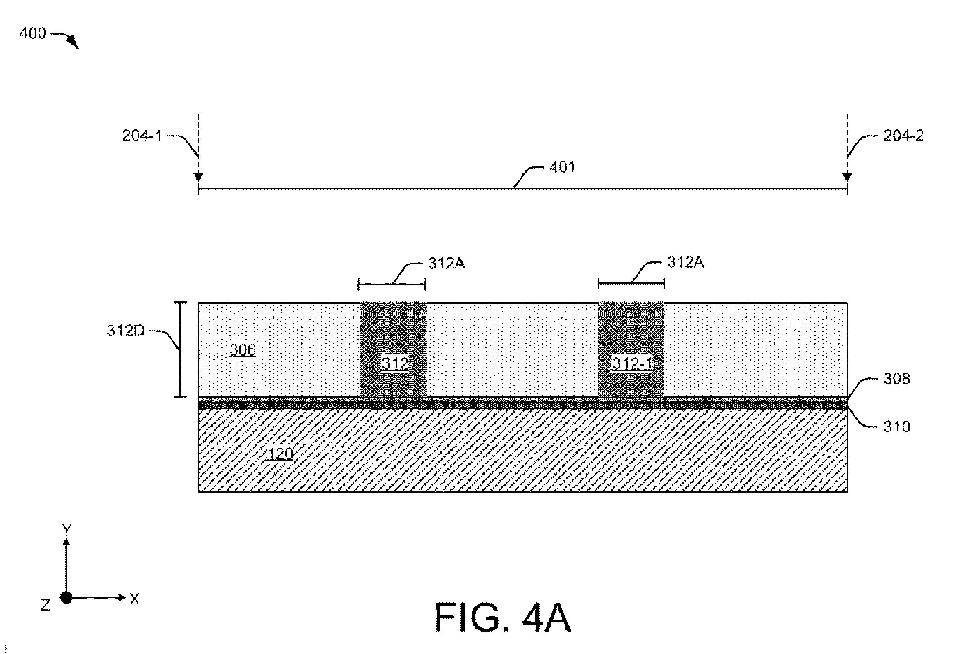

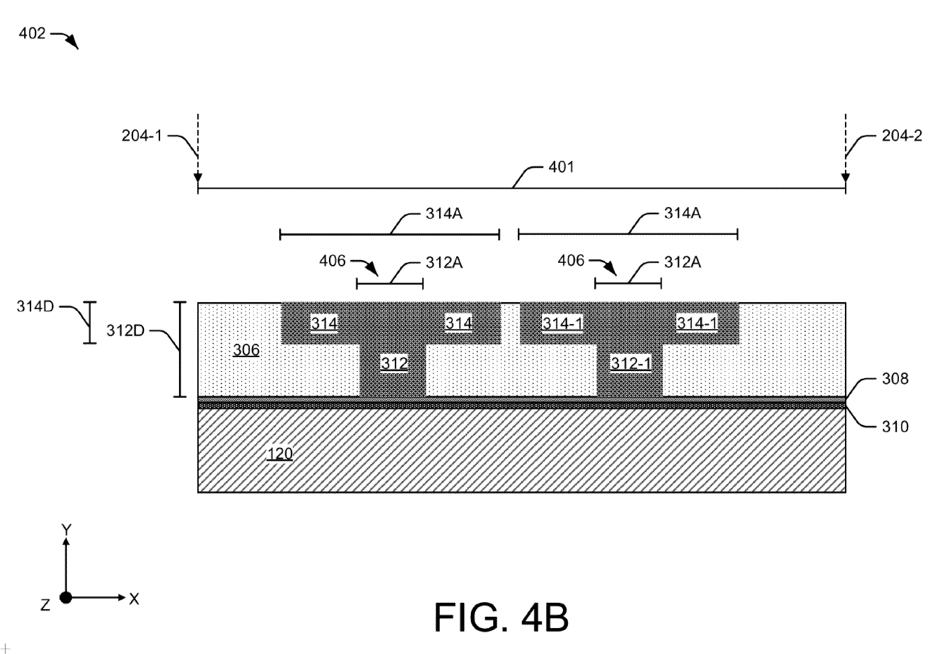

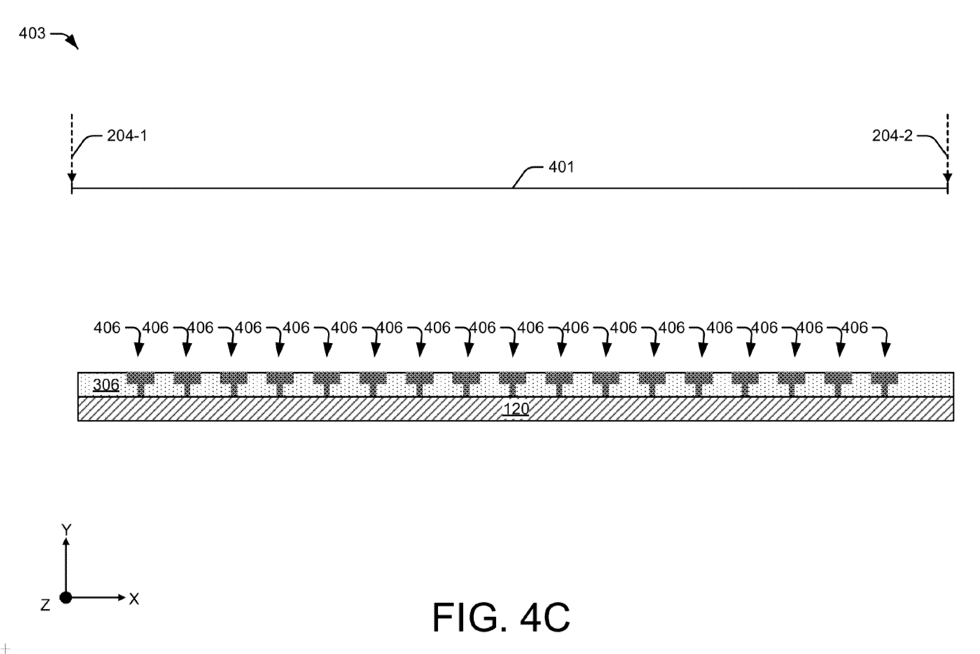

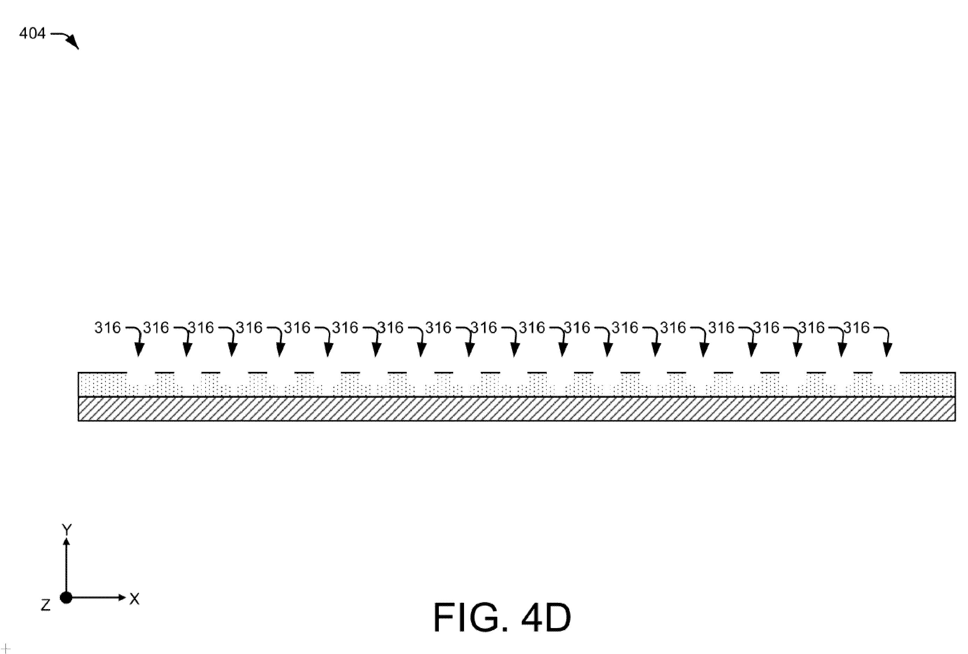

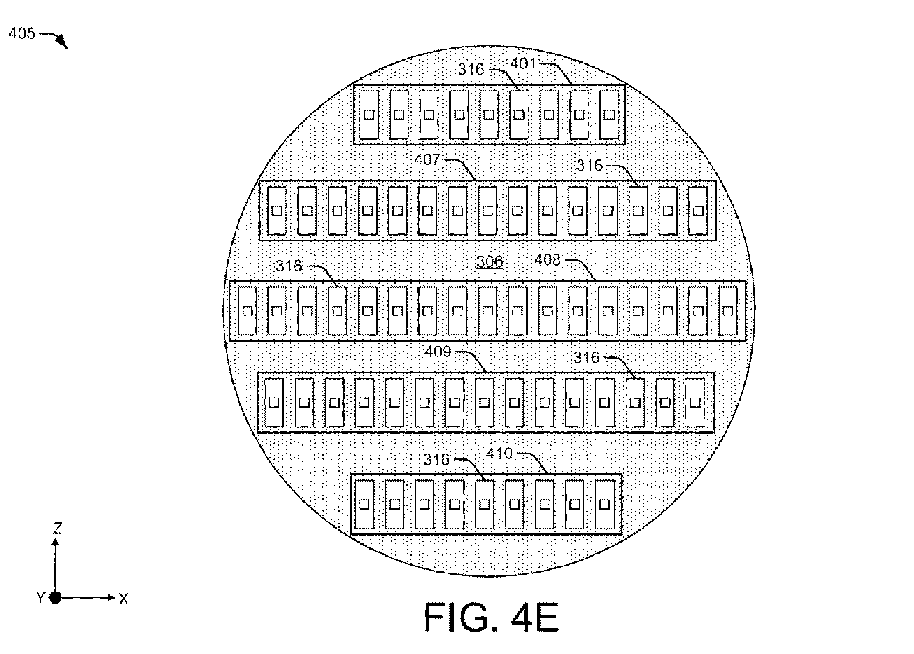

Figures 4A, 4B, 4C, 4D, and 4Eillustrate schematic representations of forming a plurality of dual damascene structures 316 in a photoresist 306 disposed over a substrate 120. Figure 4A illustrates a representation 400 of exposing first portions 312, 312-1 within a first region 401 of the photoresist 306 to the electromagnetic radiation 204 emitted from the radiation source 202 at the first dose. In some embodiments, the first region 401 defines a portion of the photoresist 306 within which the first portions 312, 312-1 can be exposed to the electromagnetic radiation 204 emitted by the radiation source 202 by actuating/activating the mirrors of the DMD 210 to direct the electromagnetic radiation 204 within the first range 204-1, 204-2 in the X-direction. Accordingly, in one or more embodiments, the first portions 312, 312-1 may be exposed to the electromagnetic radiation 204 within the first region 401 without changing an alignment of the radiation source 202 and the photoresist 306 or realigning the radiation source 202 and the photoresist 306.

Figure 4B illustrates a representation 402 of exposing second portions 314, 314-1 within the first region 401 of a photoresist 306 to the electromagnetic radiation 204 emitted from the radiation source 202 at the second dose. In one or more embodiments, the first region 401 defines a portion of the photoresist 306 within which the second portions 314, 314-1 may be exposed to the electromagnetic radiation 204 emitted by the radiation source 202 by actuating/activating the mirrors of the DMD 210 to direct the electromagnetic radiation 204 within the first range 204-1, 204-2 in the X-direction. Thus, in some embodiments, the second portions 314, 314-1 can be exposed to the electromagnetic radiation 204 within the first region 401 without changing an alignment of the radiation source 202 and the photoresist 306 or realigning the radiation source 202 and the photoresist 306. Notably, the first portion 312 and the second portion 314 collectively form an exposed portion 406. For instance, the first portion 312-1 and the second portion 314-1 also collectively form an exposed portion 406. By leveraging the first region 401 to form the exposed portions 406, the described techniques improve both total processing time and final structure quality relative to conventional techniques. In a first example, the exposed portions 406 can be formed by forming the first portions 312, 312-1 and then forming the second portions 314, 314-1. In a second example, the exposed portions 406 may be formed by forming the second portions 314, 314-1 and then forming the first portions 312, 312-1. In a third example, the exposed portions 406 can be formed by forming the first portion 312, forming the second portion 314, forming the first portion 312-1, and forming the second portion 314-1. Regardless of the order in which the exposed portions 406 are formed, many exposed portions 406 can be formed within the first region 401 in a single scan/pass and without realigning the radiation source 202 and the photoresist 306.

Figure 4C illustrates a representation 403 of additional exposed portions 406 formed within the first region 401. Figure 4D illustrates a representation 404 of a plurality of dual damascene structures 316 formed in a photoresist 306. The developer solution (not shown) is applied to the representation 403 to remove the exposed portions 406 from the plurality of dual damascene structures 316 in the photoresist 306. Figure 4E illustrates a plan view 405 of a plurality of dual damascene structures 316. The plan view 405 illustrates the first region 401 as well as additional regions 407-410. In each of the additional regions 407-410, the first portions 312, 312-1 and the second portions 314, 314-1 can be formed by actuating/activating the mirrors of the DMD 210 to direct the electromagnetic radiation 204 within the first range 204-1, 204-2 in the X-direction. Accordingly, the exposed portions 406 can be formed in each of the additional regions 407-410 and a plurality of dual damascene structures 316 can be fabricated in each of the additional regions 407-410 without performing a single realignment of the radiation source 202 and the photoresist 306. As shown, the one or more processors of the controller 122 execute instructions which cause the one or more processors to form the plurality of damascene structures 316 with smooth surface features in one scan/pass such that potential position drifts between scans/passes are eliminated. This is not possible using conventional techniques which are limited to forming structures with non-smooth surfaces that are "rippled" or performing realignments of the photoresist 306 and the radiation source 202.

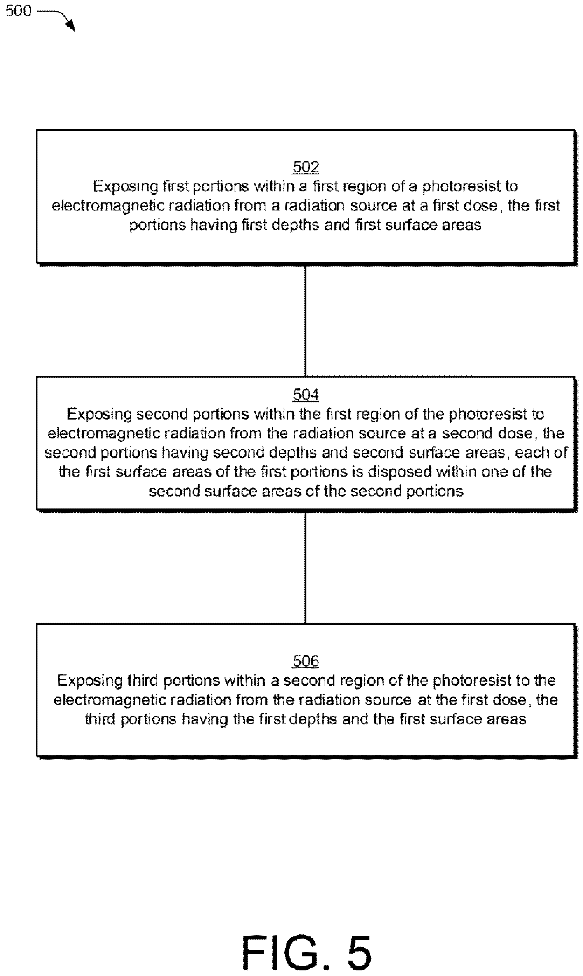

Figure 5 is a process flow diagram illustrating a method 500 for exposing multiple portions of a photoresist to electromagnetic radiation from a radiation source. At operation 502, first portions within a first region of a photoresist are exposed to electromagnetic radiation from a radiation source at a first dose, the first portions having first depths and first surface areas. In some embodiments, the first portions 312, 312-1 within the first region 401 of the photoresist 306 are exposed to the electromagnetic radiation 204 from the radiation source 202 at the first dose, and the first portions 312, 312-1 of the photoresist 306 have the first depth 312D and the first surface area 312A.

At operation 504, second portions within the first region of the photoresist are exposed to electromagnetic radiation from the radiation source at a second dose, the second portions having second depths and second surface areas, each of the first surface areas of the first portions is disposed in one of the second surface areas of the second portions. In one or more embodiments, the second portions 314, 314-1 within the first region 401 of the photoresist 306 are exposed to the electromagnetic radiation 204 from the radiation source 202 at the second dose, and the second portions 314, 314-1 of the photoresist 306 have the second depth 314D and the second surface area 314A. At operation 506, third portions within a second region of the photoresist are exposed to the electromagnetic radiation from the radiation source at the first dose, the third portions having the first depths and the first surface areas. In various embodiments, first portions 312, 312-1 within the additional region 407 of the photoresist 306 are exposed to the electromagnetic radiation 204 from the radiation source 202 at the first dose, and the first portions 312, 312-1 within the additional region 407 of the photoresist 306 have the first depth 312D and the first surface area 312A. In one or more embodiments, the method 500 further includes exposing fourth portions within the second region of the photoresist to the electromagnetic radiation from the radiation source at the second dose, the fourth portions having the second depths and the second surface areas. In one or more embodiments, each of first surface areas of the third portions is disposed within one of the second surface areas of the fourth portions. In one or more embodiments, the fourth portions are exposed during a scan that includes exposing the first portions to the electromagnetic radiation from the radiation source at the first dose.

### Additional Considerations

In the above description, details are set forth by way of example to facilitate an understanding of the disclosed subject matter. It should be apparent to a person of ordinary skill in the field, however, that the disclosed implementations are exemplary and not exhaustive of all possible implementations. Thus, it should be understood that reference to the described examples is not intended to limit the scope of the disclosure. Any alterations and further modifications to the described devices, instruments, methods, and any further application of the principles of the present disclosure are fully contemplated as would normally occur to one skilled in the art to which the disclosure relates. In particular, it is fully contemplated that the features, components, and/or processes described with respect to one implementation may be combined with the features, components, and/or processes described with respect to other implementations of the present disclosure. As used herein, the term "about" may refer to a +/-10% variation from the nominal value. It is to be understood that such a variation can be included in any value provided herein.

As used herein, "a processor," "at least one processor" or "one or more processors" generally refers to a single processor configured to perform one or multiple operations or multiple processors configured to collectively perform one or more operations. In the case of multiple processors, performance of the one or more operations could be divided amongst different processors, though one processor may perform multiple operations, and multiple processors could collectively perform a single operation. Similarly, "a memory," "at least one memory" or "one or more memories" generally refers to a single memory configured to store data and/or instructions, multiple memories configured to collectively store data and/or instructions.

As used herein, a phrase referring to "at least one of" a list of items refers to any combination of those items, including single members. As an example, "at least one of: a, *b,* or c" is intended to cover: *a, b, c, a-b, a-c, b-c,* and *a-b-c*, as well as any combination with multiples of the same element (e.g., *a*-*a*, *a*-*a*-*a*, *a-a-b, a*-*a*-*c*, *a-b-b, a-c-c, b-b, b-b-b, b-b-c, c-c,* and *c-c-c* or any other ordering of a, *b,* and c).

The methods disclosed herein comprise one or more operations or actions for achieving the described method. The method operations and/or actions may be interchanged with one another without departing from the scope of the claims. In other words, unless a specific order of operations or actions is specified, the order and/or use of specific operations and/or actions may be modified without departing from the scope of the claims.

While the foregoing is directed to embodiments of the present disclosure, other and further embodiments of the disclosure may be devised without departing from the basic scope thereof, and the scope thereof is determined by the claims that follow.

## Claims

1. A method, comprising:
exposing first portions within a first region of a photoresist to electromagnetic radiation from a radiation source at a first dose, the first portions having first depths and first surface areas;
exposing second portions within the first region of the photoresist to electromagnetic radiation from the radiation source at a second dose, the second portions having second depths and second surface areas, each of the first surface areas of the first portions is disposed within one of the second surface areas of the second portions; and
exposing third portions within a second region of the photoresist to the electromagnetic radiation from the radiation source at the first dose, the third portions having the first depths and the first surface areas.

2. The method of claim 1, further comprising:
exposing fourth portions within the second region of the photoresist to the electromagnetic radiation from the radiation source at the second dose, the fourth portions having the second depths and the second surface areas, each of first surface areas of the third portions is disposed within one of the second surface areas of the fourth portions.

3. The method of claim 2, wherein the fourth portions are exposed during a scan that includes exposing the first portions to the electromagnetic radiation from the radiation source at the first dose.

4. The method of any of claims 1 to 3, wherein the first depths are greater than the second depths.

5. The method of claim 4, wherein the first depths extends from a top surface of the photoresist to a bottom surface of the photoresist.

6. The method of any of claims 1 to 5, wherein the electromagnetic radiation from the radiation source at the first dose has a first intensity and the electromagnetic radiation from the radiation source at the second dose has a second intensity, and the first intensity is greater than the second intensity.

7. The method of any of claims 1 to 5, wherein the electromagnetic radiation from the radiation source has an intensity at the first dose and the electromagnetic radiation from the radiation source has the intensity at the second dose.

8. The method of claim 7, wherein a total duration of exposure at the first dose is greater than a total duration of exposure at the second dose.

9. The method of any of claims 1 to 8, wherein removing the first portions and the second portions from the photoresist is configured to form a plurality of dual damascene structures.

10. The method of claim 9, wherein removing the second portions is configured to form trenches and/or removing the first portions is configured to form vias.

11. The method of any of claims 1 to 8, further comprising:
developing the photoresist after exposing the third portions; and
forming a plurality of dual damascene structures in the photoresist.

12. An apparatus, comprising:
a radiation source configured to direct electromagnetic radiation towards a photoresist disposed over a substrate; and
one or more non-transitory computer readable media storing executable instructions that, when executed by at least one processor, cause the at least one processor to perform a method of any of claims 1 to 11.

13. The apparatus of claim 12, wherein an intensity of the electromagnetic radiation from the radiation source at the first dose is decreased to expose the second portions to the electromagnetic radiation from the radiation source at the second dose.

14. The apparatus of claim 12, wherein the first dose includes a first total duration of exposure and the second dose includes a second total duration of exposure that is less than the first total duration of exposure.

15. A lithography system, comprising:
an electromagnetic radiation source configured to:
receive one or more user inputs specifying electromagnetic radiation at a first dose, electromagnetic radiation at a second dose, a first set of dimensions for the electromagnetic radiation at the first dose, and a second set of dimensions for the electromagnetic radiation at the second dose; and
output iterations of the electromagnetic radiation at the first dose having the first set of dimensions and the electromagnetic radiation at the second dose having the second set of dimensions; and
a substrate support configured to:
actuate relative to the electromagnetic radiation source;
expose first portions within a first region of a photoresist to the electromagnetic radiation at the first dose having the first set of dimensions;
expose second portions within the first region of the photoresist to the electromagnetic radiation at the second dose having the second set of dimensions; and
expose third portions within a second region of the photoresist to the electromagnetic radiation at the first dose having the first set of dimensions.
